(19) Europäisches Patentamt
European Patent Office
Office européen des brevets

(11) Publication number: 0 250 377 B1

# (12) EUROPEAN PATENT SPECIFICATION

(45) Date of publication of the patent specification: 25.04.90

(51) Int. Cl.⁴: G03F 7/038

(21) Application number: 87850150.1

(22) Date of filing: 07.05.87

## (54) Composition for negative photoresists and use of the composition.

(30) Priority: 15.05.86 SE 8602224

(43) Date of publication of application: 23.12.87 Bulletin 87/52

(45) Publication of the grant of the patent: 25.04.90 Bulletin 90/17

(84) Designated Contracting States: AT BE CH DE ES FR GB IT LI LU NL SE

(56) References cited:
GB-A-2 164 347
GB-B-1 311 892
SE-B-368 097
SE-B-395 971
US-A-3 625 696
US-A-3 733 200
US-A-4 172 732

(73) Proprietor: AB Wilh. Becker, Fack, S-117 83 Stockholm(SE)

(72) Inventor: Göthe, Sven, Allhelgonagatan 10, S-116 58 Stockholm(SE)
Inventor: Hult, Anders, Anbudsvägen 3C, S-183 44 Stockholm(SE)

(74) Representative: Halldin, Bo et al, Dr. Ludwig Brann Patentbyra AB Kungsgatan 3 P.O. Box 7524, S-103 92 Stockholm(SE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 250 377 B1

## Description

This invention refers to a negative resist-photoresist and its use in a process for making a negative resist-photoresist image. The process gives in a practical way a high sensitive (∿ 10 mJ/cm$^2$), water and/or alcohol developable resist/photoresist which gives image structures usable within the semi conductor manufacturing, such as integrated or printed circuits.

The development in this field has mainly been concentrated on new types of resist materials with improved sensitivity and/or improved resolution. One interesting way of improving sensitivity is the phenomenon chemical activation, which means that an initial chemical event produces a substance, e.g. a catalyst capable of trigging a series of chemical reactions giving a multiple effect. This has proved to be a good working commercial method for resist materials, which either functions by an acid catalyzed hydrolysis (positive photo resist) or by a polymerisaton mechanism (free radical polymerisation). One disadvantage with these methods is the low sensitivity and the need for organic solvents for developing.

In the Swedish patents SE 368.097 and SE 395.971 compositions for negative photo resists based on at least one polymer, at least one photopolymerisable compound and at least one photoinitiator capable to photo cure by radical polymerisation are described. Such compositions, however, have a relatively low sensitivity, meaning they need high energy for starting the polymerisation reaction. As mcst radical polymerisation systems these have a tendency for oxygen inhibition, which deleteriously influence the reaction process. They need also, however, soluble in water, a relatively high pH (addition of alkalies) in the developing bath.

In the British patent GB 2.164.347 a photopolymerisable composition for printing plates is described, where the photochemical reaction is a radical polymerisation of an acrylamide which has been condensed with a melamine derivative. Such systems have, however, low sensitivity and show oxygen inhibition.

The present invention is a new type of chemical activation, i.e. an acid catalyzed self- and/or cocondensation of polymers. These materials generate a negative image (negative photo resist) of a given pattern, where the parts exposed to radiation undergo a chemical reaction, in this case a crosslinking of the polymer, while the unexposed parts remain chemically unchanged. The polymer/polymers which are used can be crosslinked by acid catalysts. The acid is generated by exposing the applied photoresist to radiation. The polymer/polymers are soluble in water and/or various alcohols.

The present invention makes possible compositions with high sensitivity, i.e. which can be cured by relatively low energy (radiation dose), which are insensitive to the action of air oxygen, i.e. have no tendency for oxygen inhibition, and which give a good image resolution and can be developed by water or alcohol solutions without the use of hazardous solvents.

By the present invention a negative image of a given pattern can be made by the following steps:

1. A substrate is coated with a film of a polymer or mixture of polymers comprising acrylamide or metacrylamide or derivatives thereof as components, and a cationic photoinitiator. Especially compositions comprising the acrylamide derivative methyl acrylamide glycolate methylether (MAGME) haven been used.
2. The film is exposed with a pattern whereby, in exposed parts, the cationic photoinitiator is activated and generates acid.
3. The film is heated to 50–120°C. In this step the exposed parts of the film become crosslinked by the acid formed and the heat.
4. The unexposed areas of the film are washed off by dissolving in a suitable solvent, whereby a negative image has been developed. As suitable solvents water and various alcohols can be used.
5. The substrate may be of organic or inorganic origin. The process can be carried out, as an exemple, directly on a semi conductor substrate or a semi conductor substrate coated with an etchable layer, such as an organic polymer planarization layer.

Line widths between 1 micron and 10 mm have given excellent resolutions and results for semi conductor applications.

The resist material and the process have many pronounced advantages compared with older methods. Especially the high sensitivity (in the size of 10 mJ/cm$^2$) and the possibility to develop the material in water and/or various alcohols (such as ethanol, isopropanol). Radiation crosslinking processes using the radical process previously known are sensitive to oxygen and must therefor be carried out in vacuum or inert atmosphere in order to protect the reactive radicals. In the present invention cationic photoinitiators, insensitive to oxygen, are used. Furthermore, the polymerisation and/or the crosslinking process is not sensitive to oxygen. This means that the process can be carried out under normal conditions without restrictions.

The composition of the photoresist material can be varied in numerous ways. In order for the invention to function the photo resist material shall comprise at least A) one polymer or mixture of polymers comprising chemical groups which can self- or cocondense with other chemical groups under acid conditions, e.g. acid catalyis, and B) one or more cationic photoinitiators which can generate acid catalysts such as Brönsted acids or Lewis acids.

A) is a homopolymer, copolymer or mixture of polymers. Preferably acrylic polymers and their derivatives are used, but generally all polymers form unsaturated monomers can be used. Mixtures of polymers can be mixtures of acrylicbased polymers and other freeradical- and/or condensationpolymerisation polymers. For the invention to function it is necessary that at least one polymer contains acrylamide or metacrylamide or derivatives of these as a monomer component, which can self- or co-condense with other functional groups. Preferably polymers containing the acrylamide derivative methyl acrylamide glycolate methylether (MAGME) are used. Structure see below.

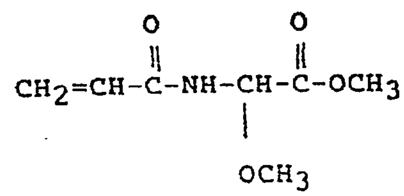

Examples of produced polymers are poly (MAGME), copolymers of MAGME and methylmetacrylate, n-butylacrylate, 2-hydroxy-ethylacrylate, 2-hydroxypropylmetacrylate, metacrylic acid, acrylic acid, acrylonitrile, styrene, octene, allylethers, paratrimethylsilylstyrene. Examples of produced mixtures of polymers:

MAGME methylmetacrylate polymer mixed with OH-functional acrylate polymers, polyesters, epoxyesters, epoxy resins, fatty acid modified polyesters (alkyds), polyurethanes, melamine resins, Si-containing polymers.

The produced MAGME-containing polymers have been 100% converted to polymers and their properties have been investigated. Molecular weight and molecular weight distribution can be adjusted by the polymerisation initiator and its concentration, by the chain transmitter, by the choice of monomers, by solvents and by the process conditions. The influence of the total MAGME concentration on the material has been investigated.

The B-component is the cationic photoinitiator which can be any of several known within the art. These include, but are not limited to, triaryl-sulphoniumsalts with or without sensitizers, diaryliodonium salts with or without sensitizers, aryldiazoniumsalts, trihalomethyl triazenes, latent UV-deblockable sulphonic acids, aryl cycloalkylferric salts with and without sensitizer, antracene. The different sensitizers make it possible to use different spectral areas for the photoresist applications.

As stated before an acid catalysis of the MAGME-polymer is necessary for the film/photoresist to crosslink. Paratoluenesulphonic acid (PTSA) has been used for studying the selfcondensation. For films of 20 microns on glass plate, at least 120°C curing temperature is necessary. If the catalyst is changed to oniumsalts which are UV-radiated, both the curing temperature and the time for crosslinking will be lower. This effect is obtained even at very small doses of radiation (~10 mJ/cm$^2$). Crosslinking temperatures between 50–120°C are obtained for the system with times down to a few minutes.

Example 1

Preparation of polymers

Methylacrylamide glycolate methylether (MAGME) (from American Cyanamid) was hot-filtrated and recrystallized from xylene (mp 70–73°C). The other monomers were purified in an aluminium oxide column.

The monomer para-trimethylsilylstyrene was synthetized from parachlorostyrene by Grignard-reaction with chlorotrimethylsilane. Azoisobutyronitrile (AIBN) was used as free-radical-initiator in all polymerisations. Carbon tetrabromide was used as chain-transmitter. The polymerisations were carried out at 60°C in a 1:1 mixture of toluene and n-butanol under $N_2$-atmosphere. The reaction lasted for 3.5 h and the polymer formed was precipitated in cold diethylether. Before further use the polymer was dissolved and precipitated once more. The polymers are described in Tab. 1.

Crosslinking experiments

Para-toluenesulphonic acid (PTSA) (I), UV-deblockable sulphonic acid (II) and triphenylsulphoniumhexafluoroantimonate (III) have been used as acid catalysts in the crosslinking experiments (structural formulaes are shown below).

Thick films (20 microns) were applied on glass plates from a methylethylketone solution (40 weight per cent solid polymer) and thin films (1 micron) were spin-applicated on a silicon plate from a cyclohexanone solution (50 weight per cent solid polymer). Radiation by an Oriel 82410 1000 W illuminator (Xenon-lamp). In table 2 the experiment parameters are summarized. In table 3 are the solubilities of the investigated polymers shown.

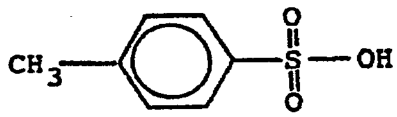

(I)

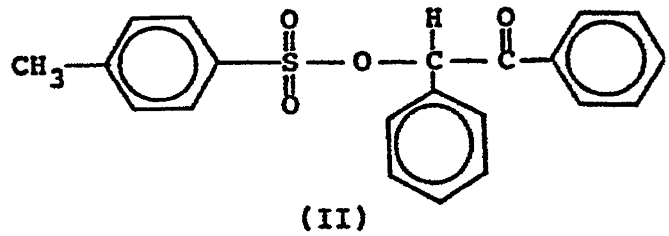

(II)

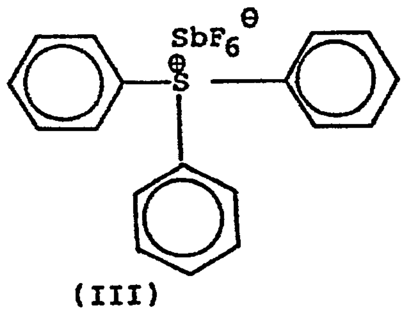

(III)

TABLE 1

| Polymer | % $CBr_4$ (w/w) | Conversion % | $\bar{M}n$ | $\bar{M}w/\bar{M}n$ | Tg °C |
|---|---|---|---|---|---|
| MAGME | 0.6 | 7 | $2.5x10^4$ | 1.93 | 78 |
| MAGME-MMA (26:74) | 0.6 | 33 | $7.4x10^4$ | 2.00 | 80 |
| MAGME-MMA (48:52) | 0.8 | 73 | $2.1x10^4$ | 2.06 | |
| MAGME-BA '39:61) | 0.6 | 24 | $4.9x10^4$ | 1.89 | |
| MAGME-EHA (46:54) | 0.6 | 34 | $3.3x10^4$ | 1.86 | |
| MAGME-STY | 0.6 | 18 | $4.4x10^4$ | 1.86 | 97 |
| MAGME-TMSiSTY 50:50) | 0.6 | 35 | $2.0x10^4$ | 2.9 | 100 |

All copolymerisations were made with 50:50-mixtures of the two comonomers. In brackets are given the composition of the copolymers.
MMA = Methylmetacrylate
BA = n-butylacrylate
EHA = 2-ethylhexylacrylate
STY = styrene
TMSiSTY = p-trimethyl silylstyrene

TABLE 2

Crosslinking of poly-MAGME and its copolymers:

| Polymer | Film-thickness (mym) | Photo-initiator | Conc. (w/w) | Radiation time (sec.) | Curing temperature (°C) | Curing time (min.) |
|---|---|---|---|---|---|---|
| MAGME | 1 | III | 10 | 3 | 100 | 2 |
| MAGME-MMA (48:52) | 20 | I | 0.3 | - | 120 | 20 |
| MAGME-MMA (2:98) | 20 | III | 5 | 4 | 100 | 5 |
| MAGME-MMA (2:98) | 20 | II | 5 | 1 | 100 | 5 |
| MAGME-BA (39:61) | 20 | I | 0.3 | - | 120 | 20 |
| MAGME-TMSiSTY (50:50) | 1 | III | 10 | 3 | 100 | 2 |

TABLE 3

Solubility of poly-MAGME and its copolymers.

| Solvent | MAGME | MAGME/MMA | MAGME/BA | MAGME/EHA | MAGME-STY |
|---|---|---|---|---|---|
| Water | x | - | - | - | - |
| Methanol | x | x | x | (x) | - |
| Isopropanol | x | x | x | x | x |
| Acetone | x | x | x | x | x |
| Ethylacetate | x | x | x | x | x |
| Chloroform | (x) | x | x | x | x |
| Toluene | - | x | x | x | x |
| n-heptane | - | - | - | x | - |

x = soluble
(x) = partially soluble
\- = insoluble

MMA = methylmetacrylate
BA = n-butylacrylate
EHA = 2-ethylhexylacrylate
STY = styrene

Example 2

The copolymer of MAGME and TMSiSTY from Example 1 is used with the cationic initiator triphenylsulphoniumhexafluoroantimonate (see Table 2). The mixture is dissolved in cyclohexanone (50 weight per cent polymer). 1 micron films have been spun on silicon plates. A precuring (100°C, 15 min.), which is not necessary, is made to eliminate rests of solvents. Exposure of an image with line width of 2 microns and a line space of 4 microns is made with Oriel 82410, 1000 W illuminator with dose 10 mJ/cm$^2$, Then postcuring at 100°C, 3 min. Development is made with isopropanol for 1 min. An excellent resolution is obtained.

Example 3

Dryresist sheets with composition according to Example 1 are prepared of a MAGME-polymer, a MAGME-styrene-polymer and a MAGME-p-trimethylsilylstyrene.

The preparation of a dryresist sheet is made by centrifuging the photoresist on a 30 micron sheet of polyethyleneterephtalate, giving a photoresist thickness after drying at 70°C of 11.7 microns.

By a laminating procedure with an equipment from Binding Corp., USA, a 25 micron copper foil on an epoxi sheet is coated with dryresist as described above. The prepared laminate with copper foil and photoresist is exposed with 12 mJ/cm$^2$ by a Xenon-lamp from Oriel Inc., USA. The image design has line width from 5 mm to 5 microns. The exposed photoresist is developed with deionized water. The laminate is dried. Resist lines with dimensions true to original are obtained down to 5 microns line width.

Example 4

A copolymer of MAG (methylacrylamide glycolate) and TMSiSTY with $\overline{M}n$ 4.7 x 10$^4$ and $\overline{M}w/\overline{M}n$~1.9 has been used with the cationic initiator triphenylsulphoniumhexafluoroantimonate (see Table 2). The mixture is dissolved in cyclohexanone (50 weight per cent polymer). 1 micron films are spun on silicon plates. A precuring (100°C, 15 min.), which is not necessary, is made to eliminate rests of solvents. Exposure of

an image with line width of 2 microns and a line space of 4 microns is made with Oriel 82410, 1000 W illuminator with dose 10 mJ/cm², Then postcuring at 80°C, 5 min. Development is made with isopropanol/water (1:1) for 1 min. An excellent resolution is obtained.

Structure of MAG:

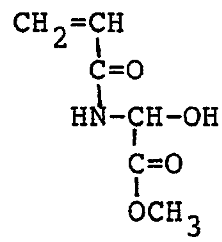

Example 5

A copolymer of BAG (butylacrylamide glycolate) and TMSiSTY with $\bar{M}n$ 4.5 × $10^4$ and $\bar{M}w/\bar{M}n \sim 1.9$ has been used with the cationic initiator triphenylsulphoniumhexafluoroantimonate (see Table 2). The mixture is dissolved in cyclohexanone (50 weight per cent polymer). 1 micron films are spun on silicon plates. A precuring (100°C, 15 min.), which is not necessary, is made to eliminate rests of solvents. Exposure of an image with line width of 2 microns and a line space of 4 microns is made with Oriel 82410, 1000 W illuminator with dose 7 mJ/cm². The postcuring at 80°C, 5 min. Development is made with isopropanol/water (1:1) for 1 min. An excellent resolution is obtained.

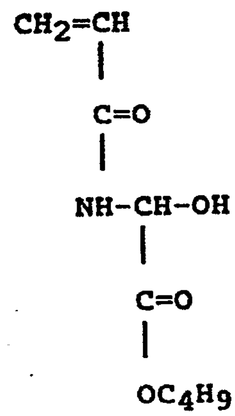

## Claims

1. A composition for negative photoresist comprising a mixture of a polymeric material (A) and one or more photoinitiators (B), characterized in that the material A consists of a homopolymer, copolymer or a mixture of polymers where acrylamide, methacrylamide or derivatives of these is a part of at least one of the polymers present and which part contains chemical groups which can self- or cocondense with other chemical groups under acid conditions, i.e. acid catalysis, such as amide, hydroxyl, ester or ether groups, and that the material B consists of one or more cationic photoinitiators which can generate acid catalysts such as Brönsted acids or Lewis acids.

2. A composition of claim 1, characterized in that MAGME, methylacrylamide glycolate methylether,

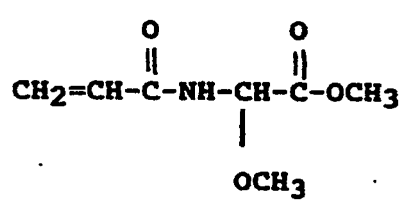

is a part of at least one of the polymers in material A.

3. A composition of claim 1, characterized in that MAG, methylacrylamide glycolate,

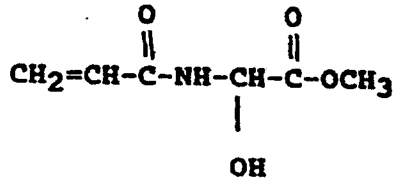

is a part of at least one of the polymers in material A.

4. A composition of claim 1, characterized in that BAG, butylacrylamide glycolate,

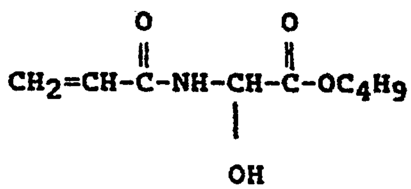

is a part of at least one of the polymers in material A.

5. Use of a negative photoresist upon an organic or inorganic substrate, characterized in that a composition according to any of the claims 1–4 is applied.

**Patentansprüche**

1. Zusammensetzung für ein negatives Fotoresist, umfassend eine Mischung aus einem polymeren Material (A) und einen oder mehrere Fotoinitiatoren (B), dadurch gekennzeichnet, dass das Material (A) aus einem Homopolymer, Copolymer oder einer Mischung von Polymeren besteht, worin Acrylamid, Methacrylamid oder Derivate davon ein Teil von wenigstens einem der vorhandenen Polymere ist und dieser Teil chemische Gruppen enthält, die selbst oder mit anderen chemischen Gruppen unter sauren Bedingungen, d.h. saurer Katalyse cokondensiert werden können, wie Amid-, Hydroxyl-, Ester- oder Ethergruppen, und dass das Material (B) aus einem oder mehreren kationischen Fotoinitiatoren besteht, die saure Katalysatoren hervorbringen können, wie Brönsted-Säuren oder Lewis-Säuren.

2. Zusammensetzung nach Anspruch 1, dadurch gekennzeichnet, dass MAGME, Methylacrylamidglykolatmethylether,

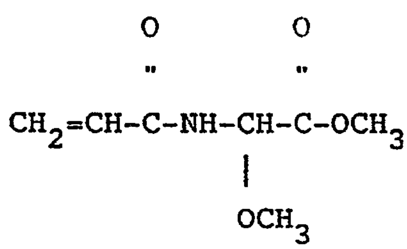

ein Teil von wenigstens einem der Polymere in Material (A) ist.

3. Zusammensetzung nach Anspruch 1, dadurch gekennzeichnet, dass MAG, Methylacrylamidglykolat,

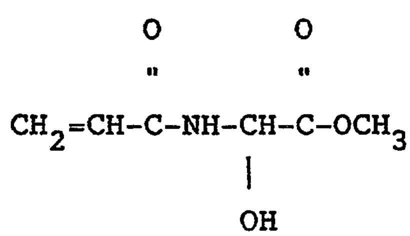

ein Teil von wenigstens einem der Polymere in Material (A) ist.

4. Zusammensetzung nach Anspruch 1, dadurch gekennzeichnet, dass BAG, Butylacrylamidglykolat,

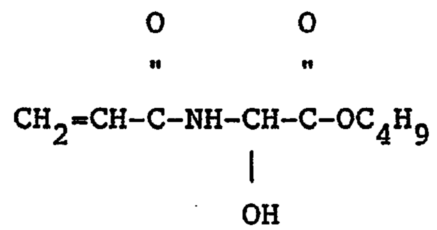

ein Teil von wenigstens einem der Polymere in Material (A) ist.

5. Verwendung eines negativen Fotoresists auf einem organischen oder anorganischen Substrat, dadurch gekennzeichnet, dass eine Zusammensetzung nach einem oder mehreren der Ansprüche 1 bis 4 angewandt ist.

**Revendications**

1. Composition pour photoréserve négative comprenant un mélange d'une matière polymère (A) et d'un ou de plusieurs photoinitiateurs (B), caractérisée en ce que la matière (A) consiste en un homopolymère, un copolymère ou un mélange de polymères dans lequel l'acrylamide, le méthacrylamide ou leurs dérivés est une partie d'au moins l'un des polymères présents et laquelle partie contient des groupes chimiques qui peuvent s'auto- ou se co-condenser avec d'autres groupes chimiques dans des conditions acides, c'est-à-dire une catalyse acide, comme des groupes amide, hydroxy, ester ou éther, et que la matière (B) consiste en un ou plusieurs photoinitiateurs cationiques qui peuvent générer des catalyseurs acides comme des acides de Brönsted ou des acides de Lewis.

2. Composition suivant la revendication 1, caractérisée en ce que le MAGME, l'éther méthylique d'acrylamide glycolate de méthyle,

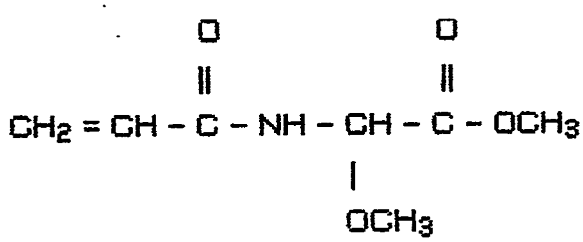

est une partie d'au moins l'un des polymères dans la matière (A).

3. Composition suivant la revendication 1, caractérisée en ce que le MAG, l'acrylamide glycolate de méthyle,

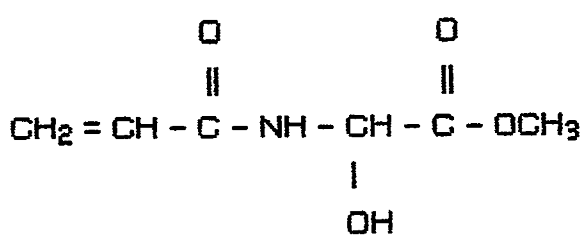

est une partie d'au moins l'un des polymères dans la matière (A).

4. Composition suivant la revendication 1, caractérisée en ce que le BAG, l'acrylamide glycolate de butyle,

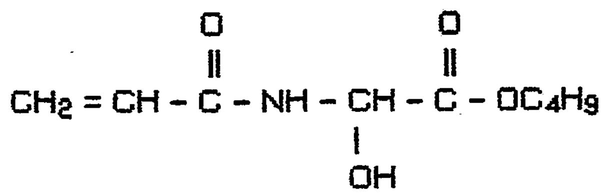

est une partie d'au moins l'un des polymères dans la matière (A).

5. Utilisation d'une photoréserve négative sur un substrat organique ou inorganique, caractérisée en ce qu'on applique une composition suivant l'une quelconque des revendications 1 à 4.